# EUROPEAN PATENT APPLICATION

(11) **EP 4 772 894 A1**
(43) Date of publication of application: **08.07.2026**
(21) Application number: 24925401.2
(22) Date of filing: 11.06.2024
(51) Int. Cl.: G01R 31/364, G01R 31/36, G01R 1/067

(54) **BATTERY TESTING MECHANISM, AND BATTERY TESTING METHOD AND DEVICE**

(30) Priority: 19.02.2024 CN 202410183179
(71) Applicant: Contemporary Amperex Technology Co., Limited, Ningde, Fujian 352100 (CN)
(72) Inventor: ZHU, Zhiqin, Ningde, Fujian 352100 (CN); WANG, Jiacai, Ningde, Fujian 352100 (CN)
(74) Representative: Ziebig Hengelhaupt Intellectual Property Attorneys Patentanwaltskanzlei PartGmbB
(86) International application number: PCT/CN2024/098446
(87) International publication number: WO 2025/175657

(57) **Abstract**

The present application provides a battery testing mechanism, a battery testing method and an apparatus, belonging to the field of battery technology. The battery testing mechanism includes: two probes (100), configured to respectively come into electrical contact with a total positive electrode and a total negative electrode of a battery to be tested; a motion mechanism (200) provided with the two probes (100) thereon, the motion mechanism (200) including a mounting plate (210) provided with a first proximity sensor assembly (320) and being configured to move toward the battery so that the two probes (100) respectively come into electrical contact with the total positive electrode and the total negative electrode of the battery; and an overpressure detection apparatus (300) provided on the motion mechanism (200), the overpressure detection apparatus (300) including a second proximity sensor assembly (330), the second proximity sensor assembly (330) cooperating with the first proximity sensor assembly (320) to detect whether a distance between these two is less than a predetermined value, and the distance less than the predetermined value indicating that the battery is pressed beyond a predetermined degree. According to the battery testing mechanism, the problem of damaging the battery due to excessive compression of the battery by the probes during the testing process can be mitigated.

## Description

### CROSS-REFERENCE

The present application refers to Chinese Patent Application No. 2024101831792, filed on February 19, 2024, and entitled "BATTERY TESTING MECHANISM, BATTERY TESTING METHOD AND APPARATUS", which is incorporated herein by reference in its entirety.

### TECHNICAL FIELD

The present application relates to the field of battery technologies, and in particular, to a battery testing mechanism, a battery testing method and a battery testing apparatus.

### BACKGROUND

Energy conservation and emission reduction are crucial to the sustainable development of the automobile industry. Electric vehicles, with their advantages in energy conservation and emission reduction, have become an important part of the sustainable development of the automobile industry. For electric vehicles, battery technologies are an important factor related to the development of the electric vehicles.

Before delivery, batteries usually need to be tested to evaluate their performance. In the related art, probes are used to electrically connected to a total output positive electrode and a total output negative electrode of the battery respectively, and appropriate test current and test time are selected to obtain parameters such as voltage and current of a battery to be tested.

### SUMMARY

The present application aims to solve at least one of the technical problems existing in the background art. To this end, an object of the present application is to provide a battery testing mechanism to mitigate the problem of damaging the battery due to excessive compression of the battery by the probes during the testing process.

Embodiments of a first aspect of the present application provide a battery testing mechanism, including: two probes, configured to respectively come into electrical contact with a total positive electrode and a total negative electrode of a battery to be tested; a motion mechanism, the two probes being provided on the motion mechanism, the motion mechanism being configured to move toward the battery so that the two probes respectively come into electrical contact with the total positive electrode and the total negative electrode of the battery; and an overpressure detection apparatus, provided on the motion mechanism and configured to press against the battery during a period when the two probes respectively come into electrical contact with the total positive electrode and the total negative electrode of the battery, and to detect whether the battery is pressed beyond a predetermined degree, where the motion mechanism includes a mounting plate, a first proximity sensor assembly is mounted on the mounting plate, and the overpressure detection apparatus includes: at least one guide rod configured to run through the mounting plate, a first end portion of the at least one guide rod being configured to press against the battery; and a second proximity sensor assembly, fixedly connected to the at least one guide rod, the second proximity sensor assembly cooperating with the first proximity sensor assembly to detect whether a distance between the second proximity sensor assembly and the first proximity sensor assembly is less than a predetermined value, where the distance less than the predetermined value indicates that the battery is pressed beyond a predetermined degree.

In the technical solution of the embodiments of the present application, the battery testing mechanism having the overpressure detection apparatus can provide safety protection for the battery to avoid damage to the battery due to excessive pressure. The provision of proximity sensor assemblies on the battery testing mechanism can further improve the accuracy of determining the degree to which the battery is pressed, enabling the battery testing mechanism of the present application to detect and respond to pressure changes more rapidly and accurately, providing a more reliable overpressure protection function. In addition, the predetermined degree to which the battery is pressed can be adjusted according to actual requirements. Appropriate safety thresholds can be set according to the dimensions and characteristics of different types of batteries to meet the needs of different application scenarios.

In some embodiments, each of the at least one guide rod includes a second end portion opposite to the first end portion, the first end portion and the second end portion are respectively located on two sides of the mounting plate, the second proximity sensor assembly is provided on any end portion of any guide rod in the at least one guide rod, and the first proximity sensor assembly is provided correspondingly to the second proximity sensor assembly. This arrangement of the sensor assemblies enhances the layout flexibility of the battery testing mechanism, allowing the positions of the sensor assemblies to be adjusted according to actual requirements.

In some embodiments, a corresponding bearing is sleeved between the second end portion of the at least one guide rod and the mounting plate, and the bearing is fixed on the mounting plate. The bearing can provide support and guidance for the linear movement of the guide rod, enabling the guide rod to perform smooth linear movement on a predetermined track.

In some embodiments, a corresponding first elastic member is sleeved between the first end portion of the at least one guide rod and the mounting plate. The provision of the elastic member facilitates the return of the guide rod to its home position.

In some embodiments, the first elastic member includes a spring. The provision of a spring between the first end portion of the guide rod and the mounting plate facilitates the return of the guide rod to its home position.

In some embodiments, the first proximity sensor assembly includes a photoelectric sensor, and the second proximity sensor assembly includes a sensing member; or the first proximity sensor assembly includes a sensing member, and the second proximity sensor assembly includes a photoelectric sensor. The photoelectric sensor and the corresponding sensing member can provide more precise detection capability for the battery testing mechanism.

In some embodiments, the photoelectric sensor includes a light emitter and a light receiver facing each other, a gap is provided between the light emitter and the light receiver, the sensing member includes a light blocking plate, and the photoelectric sensor is configured to trigger a detection signal when the light blocking plate is in the gap, the detection signal indicating that a distance between the photoelectric sensor and the sensing member is less than a predetermined value. The provision of a photoelectric sensor including a light emitter and a light receiver facing each other can provide more precise detection capability for the battery testing mechanism.

In some embodiments, the first end portion of each guide rod in the at least one guide rod is formed as a pressing block having a boss shape for pressing against the battery. Forming the first end portion of the guide rod as a pressing block having a boss shape can increase a contact area between the overpressure detection apparatus and the battery, reducing damage to the battery during pressing.

In some embodiments, the two probes and the first end portion of the at least one guide rod are provided on the same side of the mounting plate. The battery testing mechanism further includes a pressure sensor and a second elastic member. The pressure sensor is provided on the side of the mounting plate where the two probes are provided, and the second elastic member is provided between the two probes and the pressure sensor, so that the pressure sensor is capable of sensing the pressure applied to the two probes via the second elastic member. The provision of the pressure sensor and the elastic member can obtain the pressure applied to the two probes when coming into electrical contact with the total positive electrode and the total negative electrode of the battery.

In some embodiments, the second elastic member includes a spring. Providing a spring between the probe and the pressure sensor can obtain the pressure applied to the probes when coming into electrical contact with the total positive electrode and the total negative electrode of the battery.

In some embodiments, the motion mechanism is configured to move in a first direction and a second direction perpendicular to the first direction to adjust a distance to the battery. This arrangement of the motion mechanism can enhance the flexibility and adaptability of the battery testing mechanism.

In some embodiments, the two probes have multiple mounting positions on the motion mechanism to allow the position between the two probes to be adjustable. The provision of multiple mounting positions for the probes on the motion mechanism can accommodate batteries of different dimensions.

Embodiments of a second aspect of the present application provide a battery testing method, applied to a battery testing mechanism. The battery testing mechanism includes: two probes configured to respectively come into electrical contact with a total positive electrode and a total negative electrode of a battery to be tested; a motion mechanism, the two probes being provided on the motion mechanism, the motion mechanism being configured to move toward the battery so that the two probes respectively come into electrical contact with the total positive electrode and the total negative electrode of the battery; and an overpressure detection apparatus, provided on the motion mechanism and configured to press against the battery during a period when the two probes respectively come into electrical contact with the total positive electrode and the total negative electrode of the battery, where the motion mechanism includes a mounting plate, a first proximity sensor assembly is mounted on the mounting plate, and the overpressure detection apparatus includes: at least one guide rod configured to run through the mounting plate, a first end portion of the at least one guide rod being configured to press against the battery; and a second proximity sensor assembly, fixedly connected to the at least one guide rod, the second proximity sensor assembly cooperating with the first proximity sensor assembly to detect whether a distance between the second proximity sensor assembly and the first proximity sensor assembly is less than a predetermined value, where the distance less than the predetermined value indicates that the battery is pressed beyond a predetermined degree. The method includes: controlling the motion mechanism to move toward the battery to be tested so that the two probes respectively come into electrical contact with the total positive electrode and the total negative electrode of the battery; receiving a detection signal from the overpressure detection apparatus, the detection signal indicating that the battery is pressed by the overpressure detection apparatus beyond a predetermined degree, and the detection signal being generated in response to a distance between the second proximity sensor assembly and the first proximity sensor assembly being less than a predetermined value; and triggering a protection action in response to receiving the detection signal. Providing the motion mechanism to include proximity sensor assemblies can further improve the accuracy of determining the degree to which the battery is pressed, thereby providing a more reliable overpressure protection function.

In some embodiments, the protection action includes at least one of the following: the battery testing mechanism issuing an alarm; or the battery testing mechanism shutting down. Further providing the protection action can better protect the battery to be tested.

Embodiments of a third aspect of the present application provide a battery testing apparatus, applied to a battery testing mechanism. The battery testing mechanism includes: two probes, configured to respectively come into electrical contact with a total positive electrode and a total negative electrode of a battery to be tested; a motion mechanism, the two probes being provided on the motion mechanism, the motion mechanism being configured to move toward the battery so that the two probes respectively come into electrical contact with the total positive electrode and the total negative electrode of the battery; and an overpressure detection apparatus, provided on the motion mechanism and configured to press against the battery during a period when the two probes respectively come into electrical contact with the total positive electrode and the total negative electrode of the battery, where the motion mechanism includes a mounting plate, a first proximity sensor assembly is mounted on the mounting plate, and the overpressure detection apparatus includes: at least one guide rod, configured to run through the mounting plate, a first end portion of the at least one guide rod being configured to press against the battery; and a second proximity sensor assembly, fixedly connected to the at least one guide rod, the second proximity sensor assembly cooperating with the first proximity sensor assembly to detect whether a distance between the second proximity sensor assembly and the first proximity sensor assembly is less than a predetermined value, where the distance less than the predetermined value indicates that the battery is pressed beyond a predetermined degree. The apparatus includes: a first module, configured to control the motion mechanism to move toward the battery to be tested so that the two probes respectively come into electrical contact with the total positive electrode and the total negative electrode of the battery; a second module, configured to receive a detection signal from the overpressure detection apparatus, the detection signal indicating that the battery is pressed by the overpressure detection apparatus beyond a predetermined degree, and the detection signal being generated in response to a distance between the second proximity sensor assembly and the first proximity sensor assembly being less than a predetermined value; and a third module, configured to trigger a protection action in response to receiving the detection signal.

The foregoing descriptions are merely an overview of the technical solution of the present application. For a better understanding of the technical means in the present application such that they can be implemented according to the content of the specification, and to make the above and other objectives, features and advantages of the present application more obvious and easier to understand, the following describes specific embodiments of the present application.

### BRIEF DESCRIPTION OF DRAWINGS

In the accompanying drawings, unless otherwise specified, same reference signs throughout a plurality of accompanying drawings indicate the same or similar components or elements. These accompanying drawings may not necessarily be drawn to scale. It should be understood that these accompanying drawings illustrate only some embodiments disclosed in the present application and should not be construed as limitations on the scope of the present application.
FIG. 1 is a schematic structural diagram of a battery testing mechanism in some embodiments of the present application;
FIG. 2 is a schematic structural diagram of a part of a battery testing mechanism in some embodiments of the present application; and
FIG. 3 is a schematic structural diagram of a part of a battery testing mechanism in some embodiments of the present application.

### Reference signs:

100. probe, 200. motion mechanism, 300. overpressure detection apparatus;
400. pressure sensor, 500. second elastic member, 600. frame, 700. lead screw, 800. servo motor;
210. mounting plate; and 310. guide rod, 310a. first guide rod, 310b. second guide rod, 320. first proximity sensor assembly, 330. second proximity sensor assembly, 340. bearing, 350. first elastic member, 360. pressing block.

### DESCRIPTION OF EMBODIMENTS

The following describes in detail embodiments of technical solutions of the present application with reference to the accompanying drawings. The following embodiments are merely intended for a clearer description of the technical solutions of the present application and therefore are merely used as examples which do not constitute any limitation on the protection scope of the present application.

Unless otherwise defined, all technical and scientific terms used herein shall have the same meanings as commonly understood by persons skilled in the art to which the present application relates. The terms used herein are intended to merely describe the specific embodiments rather than to limit the present application. The terms "include", "comprise", and "have" and any other variations thereof in the specification, claims and brief description of drawings of the present application are intended to cover non-exclusive inclusions.

In the descriptions of the embodiments of the present application, the technical terms "first", "second", and the like are merely intended to distinguish between different objects, and shall not be understood as any indication or implication of relative importance or any implicit indication of the number, specific sequence, or primary-secondary relationship of the technical features indicated. In the description of the embodiments of the present application, "a plurality of" means at least two unless otherwise specifically defined.

In this specification, reference to "embodiment" means that specific features, structures, or characteristics described with reference to the embodiment may be included in at least one embodiment of the present application. T The word "embodiment" appearing in various places in the specification does not necessarily refer to the same embodiment or an independent or alternative embodiment that is exclusive of other embodiments. It is explicitly or implicitly understood by persons skilled in the art the embodiments described herein may be combined with other embodiments.

In the description of the embodiments of the present application, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

In the descriptions of the embodiments of the present application, the term "multiple" means more than two (inclusive). Similarly, "multiple groups" means more than two (inclusive) groups, and "multiple pieces" means more than two (inclusive) pieces.

In the description of the embodiments of the present application, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", "circumferential", and the like are based on the orientations or positional relationships as shown in the accompanying drawings. These terms are merely for ease and brevity of description of the embodiments of the present application rather than indicating or implying that the means or components mentioned must have specific orientations or must be constructed or manipulated according to specific orientations, and therefore shall not be construed as any limitation on the embodiments of the present application.

In the description of the embodiments of the present application, unless otherwise specified and defined explicitly, the terms "mount", "connect", "join", and "fasten" should be understood in their general senses. For example, they may refer to a fixed connection, a detachable connection, or an integral connection, may refer to a mechanical connection or electrical connection, and may refer to a direct connection, an indirect connection via an intermediate medium, an internal communication between two elements, or an interaction between two elements. Persons of ordinary skills in the art can understand specific meanings of these terms in the present application as appropriate to specific situations.

Currently, from the perspective of market development, application of traction batteries is being more extensive. Traction batteries have been widely configured as energy storage power supply systems such as hydroelectric power plants, thermal power plants, wind power plants, and solar power plants, and many other fields including electric transportation tools such as electric bicycles, electric motorcycles, and electric vehicles, military equipment, and aerospace. With the continuous expansion of application fields of traction batteries, market demands for traction batteries are also expanding.

Before delivery, batteries usually need to undergo performance tests, such as direct current impedance tests and consistency tests of battery cells. In the related art, the pressing parameters preset in the servo are usually used to press the probes so that the probes come into electrical contact with a total positive electrode and a total negative electrode of a battery to be tested and provide a certain pressing force. However, during the testing process, there is a situation where the battery is damaged due to excessive compression of the battery by the probes caused by inaccurate actual pressing data obtained.

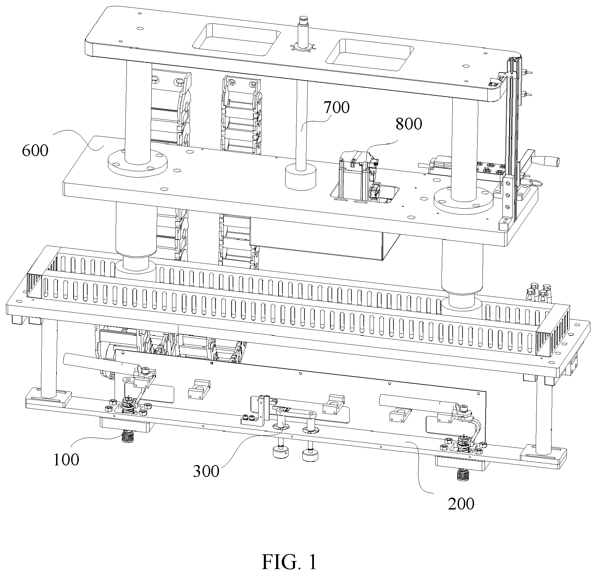

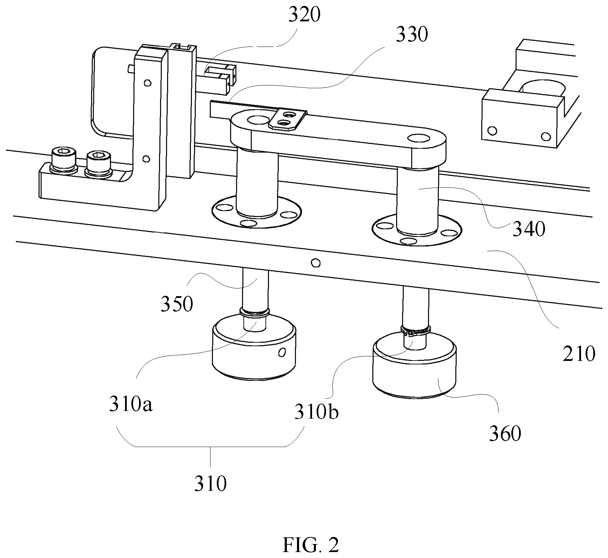

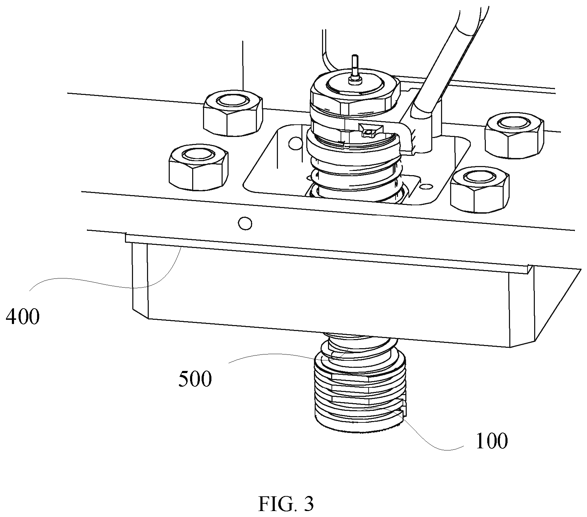

Referring to FIG. 1 to FIG. 3, FIG. 1 shows a schematic structural diagram of a battery testing mechanism in some embodiments of the present application. FIG. 2 shows a schematic structural diagram of a part of a battery testing mechanism in some embodiments of the present application. FIG. 3 shows a schematic structural diagram of a part of a battery testing mechanism in some embodiments of the present application.

Embodiments of the present application provide a battery testing mechanism, including two probes 100, a motion mechanism 200, and an overpressure detection apparatus 300. The two probes 100 are configured to respectively come into electrical contact with a total positive electrode and a total negative electrode of a battery to be tested (not shown). The two probes 100 are provided on the motion mechanism 200, and the motion mechanism 200 is configured to move toward the battery so that the two probes 100 respectively come into electrical contact with the total positive electrode and the total negative electrode of the battery. The overpressure detection apparatus 300 is provided on the motion mechanism 200 and configured to press against the battery during a period when the two probes 100 respectively come into electrical contact with the total positive electrode and the total negative electrode of the battery, and to detect whether the battery is pressed beyond a predetermined degree. The motion mechanism 200 includes a mounting plate 210, a first proximity sensor assembly 320 is mounted on the mounting plate 210. The overpressure detection apparatus 300 includes at least one guide rod 310 and a second proximity sensor assembly 330. The at least one guide rod 310 is configured to run through the mounting plate 210, and a first end portion thereof is configured to press against the battery. The second proximity sensor assembly 330 is fixedly connected to the at least one guide rod 310, and the second proximity sensor assembly 330 cooperates with the first proximity sensor assembly 320 to detect whether a distance between the second proximity sensor assembly 330 and the first proximity sensor assembly 320 is less than a predetermined value. The distance less than the predetermined value indicates that the battery is pressed beyond a predetermined degree.

In the embodiments of the present application, the "battery" may refer to a battery module composed of multiple battery cells connected in series, parallel or series-parallel, where the battery module may be, for example, a single-row module, a double-row module, or a multi-row module. The battery module has a total output positive electrode and a total output negative electrode respectively. The total output positive electrode and the total output negative electrode of the battery module together constitute the power output of the battery module for connecting to the positive and negative electrodes of an external circuit, so that electric energy can flow from the battery module to the external circuit to provide the required power for other devices.

The battery testing mechanism includes two probes 100 for contacting and pressing the total positive electrode and the total negative electrode of the battery to be tested respectively so as to extract current from the battery. In some embodiments, the end portion of the probe 100 made of a conductive material can be inserted into the total positive electrode and the total negative electrode of the battery so as to achieve current transmission and discharge process. In some embodiments, a control apparatus for controlling the discharge process of the probe 100 can be provided. The control apparatus includes, for example, a current regulator for adjusting the magnitude and stability of the current extracted from the battery, and a timer or counter for recording discharge time and electric quantity.

The battery testing mechanism further includes a motion mechanism 200. The probes 100 and the overpressure detection apparatus 300 are provided on the motion mechanism 200 so that the probes 100 and the overpressure detection apparatus 300 can move up and down with the motion mechanism 200, thereby enabling the two probes 100 to come into electrical contact with and press the total positive electrode and the total negative electrode of the battery. In some embodiments, a frame 600, a lead screw 700, and a servo motor 800 can be provided to drive the motion mechanism 200 to move toward the battery to be tested. Referring to FIG. 1, the frame 600 can be a structural frame for supporting and fixing various components of the entire battery testing mechanism. The lead screw 700 can be a helical metal rod, usually used in cooperation with a nut to convert rotational force into linear motion force through rotational motion. The servo motor 800 is configured to provide power and can control the motion of the motion mechanism 200. The servo motor 800 can perform precise position and speed adjustment according to a control signal to achieve accurate control of the motion mechanism 200. It is usually composed of a direct current motor or a stepper motor and equipped with feedback apparatuses such as encoders to provide closed-loop control. It should be understood that the frame 600, the lead screw 700 and the servo motor 800 are shown for illustrative purposes only and are not necessary for the purposes of the present disclosure.

The battery testing mechanism further includes an overpressure detection apparatus 300. The overpressure detection apparatus 300 moves with the motion of the motion mechanism 200, comes into contact and then presses against the battery, and can provide a detection signal when detecting that the pressing on the battery exceeds the set safety degree. The detection signal can trigger a protection action to reduce the possibility of damage to the battery due to excessive pressure.

In some embodiments, referring to FIG. 1 and FIG. 2, the motion mechanism 200 includes a mounting plate 210 located at the lower part of the motion mechanism 200, and the overpressure detection apparatus 300 is provided on the mounting plate 210.

In some embodiments, the overpressure detection apparatus 300 includes at least one guide rod 310 running through the mounting plate 210. Referring to FIG. 2, two guide rods 310 may be provided, that is, a first guide rod 310a and a second guide rod 310b. In some embodiments, one or more guide rods 310 may be provided, which is not limited herein. A first end portion of the guide rod 310 may be configured to press against the battery when the motion mechanism 200 moves. In some cases, the end portion of the guide rod pressing against the battery facilitates fixing the battery.

In some embodiments, a first proximity sensor assembly 320 is mounted on the mounting plate 210, and the guide rod 310 is connected to the second proximity sensor assembly 330. The first proximity sensor assembly 320 and the second proximity sensor assembly 330 can cooperate with each other to detect whether a distance between these two is less than a predetermined value, thereby indicating whether the battery to be tested is excessively compressed. Specifically, the guide rod 310 moves together with the mounting plate 210 in the motion mechanism 200. The first end portion of the guide rod 310 continues to press against the battery when coming into contact with the battery to be tested. Since the guide rod 310 runs through the mounting plate, the battery being pressed against exerts a reaction force on the guide rod 310 opposite to the movement direction of the motion mechanism 200, causing the guide rod 310 to move in the opposite direction. The second proximity sensor assembly 330 located on the guide rod 310 thus gradually approaches the first proximity sensor assembly 320 mounted on the mounting plate 210 until a detection signal is issued when the distance between these two is less than a predetermined value. The detection signal can trigger a protection action, thereby issuing an alarm or shutting down the battery testing mechanism. The predetermined value may be a pre-determined parameter characterizing the maximum pressing degree that the battery can withstand. Triggering the protection action means that the currently tested battery has a risk of being excessively pressed. At this time, an alarm can be issued for manual intervention, or the battery testing mechanism can be shut down, thereby reducing the probability of damaging the battery.

In some embodiments, the predetermined value can be set for different product parameters of the battery to be tested.

The battery testing mechanism having the overpressure detection apparatus according to the embodiments of the present application can provide safety protection for the battery to avoid damage to the battery due to excessive pressure. The provision of proximity sensor assemblies on the battery testing mechanism can further improve the accuracy of determining the degree to which the battery is pressed, enabling the battery testing mechanism of the present application to detect and respond to pressure changes more rapidly and accurately, providing a more reliable overpressure protection function. In addition, the predetermined degree to which the battery is pressed can be adjusted according to actual requirements. Appropriate safety thresholds can be set according to the dimensions and characteristics of different types of batteries to meet the needs of different application scenarios.

According to some embodiments of the present application, each of the at least one guide rod 310 includes a second end portion opposite to the first end portion, the first end portion and the second end portion are respectively located on two sides of the mounting plate 210, the second proximity sensor assembly 330 is provided on any end portion of any guide rod in the at least one guide rod 310, and the first proximity sensor assembly 320 is provided correspondingly to the second proximity sensor assembly 330.

In some embodiments, referring to FIG. 2, the guide rod 310 has a first end portion and a second end portion respectively located on two sides of the mounting plate 210.

In some embodiments, the second proximity sensor assembly 330 may be provided, for example, on the first end portion of the first guide rod 310a for pressing against the battery, or on the second end portion of the first guide rod 310a corresponding to the first end portion. The second proximity sensor assembly 330 may be provided on any end portion of any guide rod 310, which is not limited herein.

The first proximity sensor assembly 320 being provided correspondingly to the second proximity sensor assembly 330 means that the first proximity sensor assembly 320 is provided adjacent to the second proximity sensor assembly 330 so that the second proximity sensor assembly 330 can sense with the first proximity sensor assembly 320 during the movement process with the guide rod. For example, in the embodiment shown in FIG. 2, when the second proximity sensor assembly 330 is provided on the second end portion of the first guide rod 310a, the first proximity sensor assembly 320 may be mounted on a sensor bracket and provided adjacent to the second proximity sensor assembly 330, and the sensor bracket is provided on the same side of the mounting plate 210 as the second end portion. As the motion mechanism 200 moves downward, the guide rod is pressed against by the battery and moves upward, and the second proximity sensor assembly 330 also gradually approaches or comes into contact with the first proximity sensor assembly 320, thereby generating an electrical signal and triggering a switch action. The battery testing mechanism alarms or shuts down after the corresponding signal or action is detected, so as to prevent the pressing distance of the motion mechanism 200 from exceeding the pressing degree that the battery can withstand or the maximum compression amount of the probe 100.

This arrangement of the sensor assemblies enhances the layout flexibility of the battery testing mechanism, allowing the positions of the sensor assemblies to be adjusted according to actual requirements.

According to some embodiments of the present application, a corresponding bearing 340 is sleeved between the second end portion of the at least one guide rod 310 and the mounting plate 210, and the bearing 340 is fixed on the mounting plate 210.

In some embodiments, still referring to FIG. 2, a bearing 340 is sleeved over each of the first guide rod 310a and the second guide rod 310b between their respective second end portions and the mounting plate 210.

The bearing can provide support and guidance for the linear movement of the guide rod, enabling the guide rod to perform smooth linear movement on a predetermined track.

According to some embodiments of the present application, a corresponding first elastic member 350 is sleeved between the first end portion of the at least one guide rod 310 and the mounting plate 210.

In some embodiments, still referring to FIG. 2, a first elastic member 350 is also sleeved over each of the first guide rod 310a and the second guide rod 310b between their respective first end portions and the mounting plate 210. In some embodiments, one end of the first elastic member 350 can be fixed to the mounting plate 210. As the motion mechanism 200 moves downward, after the guide rod 310 presses against the battery and moves upward to compress the first elastic member 350, the first elastic member 350 enables the guide rod 310 to quickly return to its home position after the test is completed.

The provision of the elastic member facilitates the return of the guide rod to its home position.

According to some embodiments of the present application, the first elastic member 350 includes a spring.

The provision of a spring between the first end portion of the guide rod and the mounting plate facilitates the return of the guide rod to its home position.

According to some embodiments of the present application, the first proximity sensor assembly 320 includes a photoelectric sensor, and the second proximity sensor assembly 330 includes a sensing member; or the first proximity sensor assembly 320 includes a sensing member, and the second proximity sensor assembly 330 includes a photoelectric sensor.

In some embodiments, referring to FIG. 2, the first proximity sensor assembly 320 can include a photoelectric sensor or a sensing member, and the second proximity sensor assembly 330 can include a sensing member or a photoelectric sensor corresponding to the first proximity sensor assembly 320. When the sensing member and the photoelectric sensor approach or come into contact with each other, a detection signal is issued. The detection signal can trigger a protection action, issue an alarm, or shut down the battery testing mechanism.

The photoelectric sensor and the corresponding sensing member can provide more precise detection capability for the battery testing mechanism.

According to some embodiments of the present application, the photoelectric sensor includes a light emitter and a light receiver facing each other, a gap is provided between the light emitter and the light receiver, the sensing member includes a light blocking plate, and the photoelectric sensor is configured to trigger a detection signal when the light blocking plate is in the gap, the detection signal indicating that a distance between the photoelectric sensor and the sensing member is less than a predetermined value.

In some embodiments, the photoelectric sensor can include a light emitter and a light receiver. The light emitter is configured to emit light, such as infrared light or visible light. A gap is provided between the light emitter and the light receiver. The light receiver can receive the light emitted from the light emitter when there is no obstruction between the light emitter and the light receiver. When the sensing member (for example, a light blocking plate) passes through the gap, the light is blocked and cannot be received by the light receiver, which triggers a detection signal.

In some embodiments, referring to FIG. 2, a light blocking plate is provided at the second end portion of the first guide rod 310a, and a photoelectric sensor including a light emitter and a light receiver is mounted on a sensor bracket and provided adjacent to the light blocking plate. When the motion mechanism 200 moves downward, the probe 100 and the overpressure detection apparatus 300 also move downward accordingly. The probe 100 comes into contact with the total positive electrode and the total negative electrode of the battery and continues to press down. After the pressing block 360 comes into contact with the battery, the first guide rod 310a and the second guide rod 310b gradually move upward with the downward movement of the motion mechanism 200. When the light blocking plate provided at the second end portion of the first guide rod 310a passes through the gap between the light emitter and the light receiver, a detection signal is triggered. The detection signal can indicate that the distance between the photoelectric sensor and the sensing member is less than a predetermined value and trigger a protection action, thereby preventing the pressing distance of the motion mechanism 200 from exceeding the pressing distance that the battery can withstand.

The provision of a photoelectric sensor including a light emitter and a light receiver facing each other can provide more precise detection capability for the battery testing mechanism.

According to some embodiments of the present application, the first end portion of each guide rod in the at least one guide rod 310 is formed as a pressing block 360 having a boss shape for pressing against the battery.

In some embodiments, referring to FIG. 2, the first end portions of the first guide rod 310a and the second guide rod 310b are respectively formed as pressing blocks 360 having a boss shape.

Forming the first end portion of the guide rod as a pressing block having a boss shape can increase a contact area between the overpressure detection apparatus and the battery, reducing damage to the battery during pressing.

According to some embodiments of the present application, the two probes 100 and the first end portion of the at least one guide rod 310 are provided on the same side of the mounting plate 210, and the battery testing mechanism further includes a pressure sensor 400 and a second elastic member 500, the pressure sensor 400 is provided on the side of the mounting plate 210 where the two probes 100 are provided, and the second elastic member 500 is provided between the two probes 100 and the pressure sensor 400, so that the pressure sensor 400 is capable of sensing the pressure applied to the two probes 100 via the second elastic member 500.

In some embodiments, referring to FIG. 3, the battery testing mechanism further includes a pressure sensor 400 and a second elastic member 500. The pressure sensor 400 and the probe 100 are located on the same side of the mounting plate 210, and the second elastic member 500 is provided between the probe 100 and the pressure sensor 400. When the motion mechanism 200 moves downward, the probe 100 also moves downward to come into electrical contact with the total positive electrode and the total negative electrode of the battery. When the probe 100 comes into contact with the total positive electrode and the total negative electrode of the battery and continues to press down, the battery exerts pressure on the pressure sensor 400 via the second elastic member 500, so that the pressure sensor 400 is capable of sensing the pressure applied to the probe 100.

The provision of the pressure sensor and the elastic member can obtain the pressure applied to the probe when coming into electrical contact with the total positive electrode and the total negative electrode of the battery.

According to some embodiments of the present application, the second elastic member 500 includes a spring.

In some embodiments, referring to FIG. 3, the second elastic member 500 may be a spring.

Providing a spring between the probe and the pressure sensor can obtain the pressure applied to the probe when coming into electrical contact with the total positive electrode and the total negative electrode of the battery.

According to some embodiments of the present application, the motion mechanism 200 is configured to move in a first direction and a second direction perpendicular to the first direction to adjust a distance to the battery.

In some embodiments, the "first direction" may refer to a direction extending parallel to the mounting plate 210, and the "second direction" may refer to a direction extending parallel to the guide rod 310. In some embodiments, the "first direction" may refer to a direction extending parallel to the guide rod 310, and the "second direction" may refer to a direction extending parallel to the mounting plate 210. According to the actual requirements of battery testing, setting other two mutually perpendicular directions is also possible, which is not limited herein.

This arrangement of the motion mechanism can enhance the flexibility and adaptability of the battery testing mechanism.

According to some embodiments of the present application, the two probes 100 have multiple mounting positions on the motion mechanism 200 to allow the position between the two probes 100 to be adjustable.

In some embodiments, the motion mechanism 200 can have multiple mounting positions for mounting the two probes 100, and these mounting positions can be provided on, for example, mounting plates at different height levels, or at different positions on the same mounting plate. It should be understood that providing mounting positions on other parts of the battery testing mechanism is also possible, which is not limited herein.

In some embodiments, the motion mechanism 200 can further include sliding grooves as mounting positions for the two probes 100 for sliding adjustment of a distance between the two probes 100.

The provision of multiple mounting positions for the probes on the motion mechanism can accommodate batteries of different dimensions.

Embodiments of the present application further provide a battery testing method, applied to a battery testing mechanism. The battery testing mechanism includes two probes 100 configured to respectively come into electrical contact with a total positive electrode and a total negative electrode of a battery to be tested; a motion mechanism 200, the two probes 100 being provided on the motion mechanism 200, the motion mechanism 200 being configured to move toward the battery so that the two probes 100 respectively come into electrical contact with the total positive electrode and the total negative electrode of the battery; and an overpressure detection apparatus 300, provided on the motion mechanism 200 and configured to press against the battery during a period when the two probes 100 respectively come into electrical contact with the total positive electrode and the total negative electrode of the battery. The motion mechanism 200 includes a mounting plate 210, a first proximity sensor assembly 320 is mounted on the mounting plate 210, and the overpressure detection apparatus 300 includes at least one guide rod 310 and a second proximity sensor assembly 330. The at least one guide rod 310 is configured to run through the mounting plate 210, and a first end portion thereof is configured to press against the battery. The second proximity sensor assembly 330 is fixedly connected to the at least one guide rod 310, and the second proximity sensor assembly 330 cooperates with the first proximity sensor assembly 320 to detect whether a distance between the second proximity sensor assembly 330 and the first proximity sensor assembly 320 is less than a predetermined value. The distance less than the predetermined value indicates that the battery is pressed beyond a predetermined degree. The battery testing method includes: The motion mechanism 200 is controlled to move toward the battery to be tested so that the two probes 100 respectively come into electrical contact with the total positive electrode and the total negative electrode of the battery; a detection signal from the overpressure detection apparatus 300 is received, the detection signal indicating that the battery is pressed by the overpressure detection apparatus 300 beyond a predetermined degree, and the detection signal being generated in response to a distance between the second proximity sensor assembly 330 and the first proximity sensor assembly 320 being less than a predetermined value; and a protection action is triggered in response to receiving the detection signal.

Providing the motion mechanism to include proximity sensor assemblies can further improve the accuracy of determining the degree to which the battery is pressed, thereby providing a more reliable overpressure protection function.

According to some embodiments of the present application, the protection action includes at least one of the following: the battery testing mechanism issuing an alarm; or the battery testing mechanism shutting down.

Further providing the protection action can better protect the battery to be tested.

Since the method is applied to the battery testing mechanism in the above embodiments, the method has the technical effects of the above battery testing mechanism, which is not be repeated herein.

Embodiments of the present application further provide a battery testing apparatus, applied to a battery testing mechanism. The battery testing mechanism includes two probes 100, configured to respectively come into electrical contact with a total positive electrode and a total negative electrode of a battery to be tested; a motion mechanism 200, the two probes 100 being provided on the motion mechanism 200, the motion mechanism 200 being configured to move toward the battery so that the two probes 100 respectively come into electrical contact with the total positive electrode and the total negative electrode of the battery; and an overpressure detection apparatus 300, provided on the motion mechanism 200 and configured to press against the battery during a period when the two probes 100 respectively come into electrical contact with the total positive electrode and the total negative electrode of the battery. The motion mechanism 200 includes a mounting plate 210, a first proximity sensor assembly 320 is mounted on the mounting plate 210, and the overpressure detection apparatus 300 includes at least one guide rod 310 and a second proximity sensor assembly 330. The at least one guide rod 310 is configured to run through the mounting plate 210, and a first end portion thereof is configured to press against the battery. The second proximity sensor assembly 330 is fixedly connected to the at least one guide rod 310, and the second proximity sensor assembly 330 cooperates with the first proximity sensor assembly 320 to detect whether a distance between the second proximity sensor assembly 330 and the first proximity sensor assembly 320 is less than a predetermined value. The distance less than the predetermined value indicates that the battery is pressed beyond a predetermined degree. The battery testing apparatus includes: a first module, configured to control the motion mechanism 200 to move toward the battery to be tested so that the two probes 100 respectively come into electrical contact with the total positive electrode and the total negative electrode of the battery; a second module, configured to receive a detection signal from the overpressure detection apparatus 300, the detection signal indicating that the battery is pressed by the overpressure detection apparatus 300 beyond a predetermined degree, and the detection signal being generated in response to a distance between the second proximity sensor assembly 330 and the first proximity sensor assembly 320 being less than a predetermined value; and a third module, configured to trigger a protection action in response to receiving the detection signal.

The battery testing mechanism of the present application is further described below in conjunction with specific embodiments.

Referring to FIG. 1 to FIG. 3, the battery testing mechanism includes two probes 100, a motion mechanism 200, and an overpressure detection apparatus 300. The motion mechanism 200 includes a mounting plate 210, and the two probes 100 and the overpressure detection apparatus 300 are provided on the mounting plate 210.

The overpressure detection apparatus 300 includes a first guide rod 310a and a second guide rod 310b running through the mounting plate 210, each of which has an opposite first end portion and a second end portion. The first end portions of the first guide rod 310a and the second guide rod 310b are formed as pressing blocks 360 having a boss shape for pressing against the battery. The second end portion of the first guide rod 310a is provided with a second proximity sensor assembly 330, and a first proximity sensor assembly 320 is mounted on a sensor bracket and provided adjacent to the second proximity sensor assembly 330. A bearing 340 is sleeved over each of the first guide rod 310a and the second guide rod 310b between their respective second end portions and the mounting plate 210, and a spring is sleeved over each of the first guide rod 310a and the second guide rod 310b between their respective first end portions and the mounting plate 210.

The battery testing mechanism further includes a pressure sensor 400 provided on the same side as the probe 100 and a spring provided between the probe 100 and the pressure sensor 400.

When the motion mechanism 200 moves downward, the probe 100 and the overpressure detection apparatus 300 also move downward accordingly. When the probe 100 comes into contact with the total positive electrode and the total negative electrode of the battery and continues to press down, the spring provided between the probe 100 and the pressure sensor 400 exerts pressure on the pressure sensor 400 to sense the pressure applied to the probe 100. After the pressing block 360 comes into contact with the battery, the first guide rod 310a and the second guide rod 310b gradually move upward with the downward movement of the motion mechanism 200. When the second proximity sensor assembly 330 provided at the second end portion of the first guide rod 310a approaches or comes into contact with the first proximity sensor assembly 320, an electrical signal is generated and a switch action is triggered. The battery testing mechanism alarms or shuts down after the corresponding signal or action is detected, so as to prevent the pressing distance of the motion mechanism 200 from exceeding the pressing distance that the battery can withstand or the maximum compression amount of the probe 100.

In conclusion, it should be noted that the foregoing embodiments are merely for describing the technical solutions of the present application rather than for limiting the present application. Although the present application has been described in detail with reference to the foregoing embodiments, persons of ordinary skill in the art should appreciate that they can still make modifications to the technical solutions described in the embodiments or make equivalent replacements to some or all technical features thereof without departing from the scope of the technical solutions of the embodiments of the present application. All such modifications and equivalent replacements shall fall within the scope of claims and specification of the present application. In particular, as long as there is no structural conflict, the various technical features mentioned in the embodiments can be combined in any manner. The present application is not limited to the specific embodiments disclosed in this specification, but includes all technical solutions falling within the scope of the claims.

## Claims

1. A battery testing mechanism, comprising:
two probes (100), configured to respectively come into electrical contact with a total positive electrode and a total negative electrode of a battery to be tested;
a motion mechanism (200), the two probes (100) being provided on the motion mechanism (200), the motion mechanism (200) being configured to move toward the battery so that the two probes (100) respectively come into electrical contact with the total positive electrode and the total negative electrode of the battery; and
an overpressure detection apparatus (300), provided on the motion mechanism (200) and configured to press against the battery during a period when the two probes (100) respectively come into electrical contact with the total positive electrode and the total negative electrode of the battery, and to detect whether the battery is pressed beyond a predetermined degree,
wherein the motion mechanism (200) comprises a mounting plate (210), a first proximity sensor assembly (320) is mounted on the mounting plate (210), and the overpressure detection apparatus (300) comprises:
at least one guide rod (310), configured to run through the mounting plate (210), a first end portion of the at least one guide rod (310) being configured to press against the battery; and
a second proximity sensor assembly (330), fixedly connected to the at least one guide rod (310), the second proximity sensor assembly (330) cooperating with the first proximity sensor assembly (320) to detect whether a distance between the second proximity sensor assembly (330) and the first proximity sensor assembly (320) is less than a predetermined value, wherein the distance less than the predetermined value indicates that the battery is pressed beyond a predetermined degree.

2. The battery testing mechanism according to claim 1, wherein each of the at least one guide rod (310) comprises a second end portion opposite to the first end portion, the first end portion and the second end portion are respectively located on two sides of the mounting plate (210), the second proximity sensor assembly (330) is provided on any end portion of any guide rod in the at least one guide rod (310), and the first proximity sensor assembly (320) is provided correspondingly to the second proximity sensor assembly (330).

3. The battery testing mechanism according to claim 2, wherein a corresponding bearing (340) is sleeved between the second end portion of the at least one guide rod (310) and the mounting plate (210), and the bearing (340) is fixed on the mounting plate (210).

4. The battery testing mechanism according to any one of claims 1 to 3, wherein a corresponding first elastic member (350) is sleeved between the first end portion of the at least one guide rod (310) and the mounting plate (210).

5. The battery testing mechanism according to claim 4, wherein the first elastic member (350) comprises a spring.

6. The battery testing mechanism according to any one of claims 1 to 5, wherein the first proximity sensor assembly (320) comprises a photoelectric sensor, and the second proximity sensor assembly (330) comprises a sensing member; or
the first proximity sensor assembly (320) comprises a sensing member, and the second proximity sensor assembly (330) comprises a photoelectric sensor.

7. The battery testing mechanism according to claim 6, wherein the photoelectric sensor comprises a light emitter and a light receiver facing each other, a gap is provided between the light emitter and the light receiver, the sensing member comprises a light blocking plate, and the photoelectric sensor is configured to trigger a detection signal when the light blocking plate is in the gap, the detection signal indicating that a distance between the photoelectric sensor and the sensing member is less than a predetermined value.

8. The battery testing mechanism according to any one of claims 1 to 7, wherein the first end portion of each guide rod in the at least one guide rod (310) is formed as a pressing block (360) having a boss shape for pressing against the battery.

9. The battery testing mechanism according to any one of claims 1 to 8, wherein the two probes (100) and the first end portion of the at least one guide rod (310) are provided on the same side of the mounting plate (210), and the battery testing mechanism further comprises a pressure sensor (400) and a second elastic member (500), the pressure sensor (400) is provided on a side of the mounting plate (210) where the two probes (100) are provided, and the second elastic member (500) is provided between the two probes (100) and the pressure sensor (400), so that the pressure sensor (400) is capable of sensing the pressure applied to the two probes (100) via the second elastic member (500).

10. The battery testing mechanism according to claim 9, wherein the second elastic member (500) comprises a spring.

11. The battery testing mechanism according to any one of claims 1 to 10, wherein the motion mechanism (200) is configured to move in a first direction and a second direction perpendicular to the first direction to adjust a distance to the battery.

12. The battery testing mechanism according to any one of claims 1 to 11, wherein the two probes (100) have multiple mounting positions on the motion mechanism (200) to allow a position between the two probes (100) to be adjustable.

13. A battery testing method applied to a battery testing mechanism, the battery testing mechanism comprising: two probes (100), configured to respectively come into electrical contact with a total positive electrode and a total negative electrode of a battery to be tested; a motion mechanism (200), two probes (100) being provided on the motion mechanism (200), the motion mechanism (200) being configured to move toward the battery so that the two probes (100) respectively come into electrical contact with the total positive electrode and the total negative electrode of the battery; and an overpressure detection apparatus (300), provided on the motion mechanism (200) and configured to press against the battery during a period when the two probes (100) respectively come into electrical contact with the total positive electrode and the total negative electrode of the battery, wherein the motion mechanism (200) comprises a mounting plate (210), a first proximity sensor assembly (320) is mounted on the mounting plate (210), and the overpressure detection apparatus (300) comprises: at least one guide rod (310), configured to run through the mounting plate (210), a first end portion of the at least one guide rod (310) being configured to press against the battery; and a second proximity sensor assembly (330), fixedly connected to the at least one guide rod (310), the second proximity sensor assembly (330) cooperating with the first proximity sensor assembly (320) to detect whether a distance between the second proximity sensor assembly (330) and the first proximity sensor assembly (320) is less than a predetermined value, wherein the distance less than the predetermined value indicates that the battery is pressed beyond a predetermined degree, the method comprising:
controlling the motion mechanism (200) to move toward the battery to be tested so that the two probes (100) respectively come into electrical contact with the total positive electrode and the total negative electrode of the battery;
receiving a detection signal from the overpressure detection apparatus (300), the detection signal indicating that the battery is pressed by the overpressure detection apparatus (300) beyond a predetermined degree, and the detection signal being generated in response to a distance between the second proximity sensor assembly (330) and the first proximity sensor assembly (320) being less than a predetermined value; and
triggering a protection action in response to receiving the detection signal.

14. The method according to claim 13, wherein the protection action comprises at least one of the following:
the battery testing mechanism issuing an alarm; or
the battery testing mechanism shutting down.

15. A battery testing apparatus, applied to a battery testing mechanism, the battery testing mechanism comprising: two probes (100), configured to respectively come into electrical contact with a total positive electrode and a total negative electrode of a battery to be tested; a motion mechanism (200), the two probes (100) being provided on the motion mechanism (200), the motion mechanism (200) being configured to move toward the battery so that the two probes (100) respectively come into electrical contact with the total positive electrode and the total negative electrode of the battery; and an overpressure detection apparatus (300), provided on the motion mechanism (200) and configured to press against the battery during a period when the two probes (100) respectively come into electrical contact with the total positive electrode and the total negative electrode of the battery, wherein the motion mechanism (200) comprises a mounting plate (210), a first proximity sensor assembly (320) is mounted on the mounting plate (210), and the overpressure detection apparatus (300) comprises: at least one guide rod (310), configured to run through the mounting plate (210), a first end portion of the at least one guide rod (310) being configured to press against the battery; and a second proximity sensor assembly (330), fixedly connected to the at least one guide rod (310), the second proximity sensor assembly (330) cooperating with the first proximity sensor assembly (320) to detect whether a distance between the second proximity sensor assembly (330) and the first proximity sensor assembly (320) is less than a predetermined value, wherein the distance less than the predetermined value indicates that the battery is pressed beyond a predetermined degree, the battery testing apparatus comprising:
a first module, configured to control the motion mechanism (200) to move toward the battery to be tested so that the two probes (100) respectively come into electrical contact with the total positive electrode and the total negative electrode of the battery;
a second module, configured to receive a detection signal from the overpressure detection apparatus (300), the detection signal indicating that the battery is pressed by the overpressure detection apparatus (300) beyond a predetermined degree, and the detection signal being generated in response to a distance between the second proximity sensor assembly (330) and the first proximity sensor assembly (320) being less than a predetermined value; and
a third module, configured to trigger a protection action in response to receiving the detection signal.
